# EUROPEAN PATENT APPLICATION

(11) **EP 1 589 382 A1**
(43) Date of publication of application: **26.10.2005**
(21) Application number: 04704339.3
(22) Date of filing: 22.01.2004
(51) Int. Cl.: G03G 15/01, G03G 15/00, H01L 27/146

(54) **MULTIPLE IMAGE FORMATION POSITION SHIFT DETECTION DEVICE, IMAGE CONCENTRATION DETECTION DEVICE, AND MULTIPLE IMAGE FORMATION DEVICE**

(30) Priority: 24.01.2003 JP 2003016559
(71) Applicant: HAMAMATSU PHOTONICS K. K., Hamamatsu-shi, Shizuoka 435-8558 (JP)
(72) Inventor: SUGIYAMA, Yukinobu, Hamamatsu Photonics K.K., Hamamatsu-shi, Shizuoka 435-8558 (JP); MIZUNO, Seiichiro, Hamamatsu Photonics K.K., Hamamatsu-shi, Shizuoka 435-8558 (JP); OIKAWA, Toshihiro, Hamamatsu Photonics K.K., Hamamatsu-shi, Shizuoka 435-8558 (JP)
(74) Representative: Frost, Alex John
(86) International application number: PCT/JP2004/000551
(87) International publication number: WO 2004/066032

(57) **Abstract**

A photodetecting unit 5 comprises a photosensitive region 10, a first signal processing circuit 20, and a second signal processing circuit 30. In photosensitive region 10, pixels 11ₘₙ are arrayed two-dimensionally in M rows and N columns. One pixel is arranged by adjacently positioning in the same plane a photosensitive portion 12ₘₙ and a photosensitive portion 13ₘₙ, each outputting a current that is in accordance with the intensity of light that is made incident thereon. Across each of the pluralities of pixels 11₁₁ to 11_{1N}, ···, 11_{M1} to 11_{MN}, aligned in a first direction in the two-dimensional array, one photosensitive portion 12ₘₙ of each corresponding pixel is electrically connected to the same photosensitive portion 12ₘₙ of each of the other corresponding pixels. Also across each of the pluralities of pixels 11₁₁ to 11_{M1}, ···, 11_{1N} to 11_{MN}, aligned in a second direction in the two-dimensional array, the other photosensitive portion 13ₘₙ of each corresponding pixel is connected to the same photosensitive portion 13ₘₙ of each of the other corresponding pixels.

## Description

### Technical Field

This invention concerns a multiple image forming position deviation detecting device, an image density detecting device, and a multiple image forming device.

### Background Art

As a multiple image forming device, there is known a composition, wherein a plurality of image forming units are disposed for forming a multiple image, images that differ in color are respectively formed by the respective image forming units, and a multiple image forming position deviation detection patterns (positioning patterns), for correction of the deviation of the transfer positions of the respective images that are transferred and overlapped on a transfer material, are read by a CCD image sensor (see, for example, Patent Document 1). With the composition of Patent Document 1, density detection patterns, for controlling the densities of the images that are transferred onto the transfer material, are also read by the CCD image sensor.

[Patent Document 1] Japanese Published Unexamined Patent Application No. H1-167769

### Disclosure of the Invention

However, the following issue arises in using a CCD image sensor to read multiple image forming position deviation detection patterns or density detection patterns. That is, in order to obtain the light intensity distribution of a single frame with a CCD image sensor, data processing must be performed on all pixels (for example, when there are m × n pixels, m × n times of data processing must be performed) and the time for data processing becomes long. Also, a high-performance and high-speed signal processing circuit is required for performing the data processing.

This invention has been made in view of the above points and a first object thereof is to provide a multiple image forming position deviation detecting device, with which high speed and simplification of composition can be realized for a process of detecting multiple image forming position deviation detection patterns.

A second object is to provide an image density detecting device, with which high speed and simplification of composition can be realized for a process of detecting image density detection patterns.

A third object is to provide a multiple image forming device, with which high speed and simplification of composition can be realized for a process of detecting multiple image forming position deviation detection patterns or image density detection patterns.

In order to achieve the above object, this invention provides in a multiple image forming position deviation detecting device, wherein, in order to detect the deviations of transfer positions of images in forming a multiple image, multiple image forming position deviation detection patterns, formed on a surface of an object to be detected, are detected by a photodetecting means having a photosensitive region, in which pixels are arrayed two-dimensionally, a multiple image forming position deviation detecting device wherein in the photodetecting means, a single pixel is arranged by adjacently positioning within the same plane a plurality of photosensitive portions, each outputting a current in accordance with the intensity of light made incident thereon, and in each plurality of pixels that are aligned in a first direction of the two-dimensional array, one photosensitive portion among the plurality of photosensitive portions making up each corresponding pixel is electrically connected to the same photosensitive portion of each of the other corresponding pixels, and in each plurality of pixels that are aligned in a second direction of the two-dimensional array, another photosensitive portion among the plurality of photosensitive portions making up each corresponding pixel is electrically connected to the same photosensitive portion of each of the other corresponding pixels.

With this invention's multiple image forming position deviation detecting device, light that is made incident on a single pixel is detected by each of the plurality of photosensitive portions making up the pixel, and a current that is in accordance with the light intensity is output according to each photosensitive portion. Since the photosensitive portions are electrically connected across each plurality of pixels aligned in the first direction of the two-dimensional array, the currents from these photosensitive portions are sent in the first direction. Also, since the photosensitive portions are electrically connected across each plurality of pixels aligned in the second direction of the two-dimensional array, the currents from these photosensitive portions are sent in the second direction. Since the currents from the one photosensitive portions, which are electrically connected across each plurality of pixels aligned in the first direction of the two-dimensional array, are sent in the first direction and the currents from the other photosensitive portions, which are electrically connected across each plurality of pixels aligned in the second direction of the two-dimensional array, are sent in the second direction, a luminance profile in the first direction and a luminance profile in the second direction can be obtained independently of each other. As a result, the luminance profile in the first direction and luminance profile in the second direction of a multiple image forming position deviation detection pattern can be detected at high speed by an extremely simple composition wherein a plurality of photosensitive portions are disposed in a single pixel.

This invention also provides in an image density detecting device, with which, in order to detect the densities of an image, image density detection patterns, formed on a surface of an object to be detected, are detected by a photodetecting means having a photosensitive region, in which pixels are arrayed two-dimensionally, an image density detecting device wherein in the photodetecting means, a single pixel is arranged by adjacently positioning within the same plane a plurality of photosensitive portions, each outputting a current in accordance with the intensity of light made incident thereon, and in each plurality of pixels that are aligned in a first direction of the two-dimensional array, one photosensitive portion among the plurality of photosensitive portions making up each corresponding pixel is electrically connected to the same photosensitive portion of each of the other corresponding pixels, and in each plurality of pixels that are aligned in a second direction of the two-dimensional array, another photosensitive portion among the plurality of photosensitive portions making up each corresponding pixel is electrically connected to the same photosensitive portion of each of the other corresponding pixels.

With this invention's image density detecting device, light that is made incident on a single pixel is detected by each of the plurality of photosensitive portions making up the pixel, and a current that is in accordance with the light intensity is output according to each photosensitive portion. Since the photosensitive portions are electrically connected across each plurality of pixels aligned in the first direction of the two-dimensional array, the currents from these photosensitive portions are sent in the first direction. Also, since the photosensitive portions are electrically connected across each plurality of pixels aligned in the second direction of the two-dimensional array, the currents from these photosensitive portions are sent in the second direction. Since the currents from the one photosensitive portions, which are electrically connected across each plurality of pixels aligned in the first direction of the two-dimensional array, are sent in the first direction and the currents from the other photosensitive portions, which are electrically connected across each plurality of pixels aligned in the second direction of the two-dimensional array, are sent in the second direction, a luminance profile in the first direction and a luminance profile in the second direction can be obtained independently of each other. As a result, the luminance profile in the first direction and the luminance profile in the second direction of an image density detection pattern can be detected at high speed by an extremely simple composition wherein a plurality of photosensitive portions are disposed in a single pixel.

The above-described photodetecting means preferably comprises a first signal processing circuit, which reads the output from each of the photosensitive portions that are electrically connected across each plurality of pixels aligned in the first direction to detect the luminance profile in the second direction of the two-dimensional array based on these outputs, and a second signal processing circuit, which reads the output from each of the photosensitive portions that are electrically connected across each plurality of pixels aligned in the second direction and detects the luminance profile in the first direction of the two-dimensional array based on these outputs.

This invention's multiple image forming device comprises a plurality of image forming units, respectively forming different images for forming a multiple image, and the above-described multiple image forming position deviation detecting device, and wherein the deviations of the transfer positions of the images, respectively formed by the image forming units, are detected by means of the multiple image forming position deviation detecting device.

Since this invention's multiple image forming device is equipped with the above-described multiple image forming position deviation detecting device, the luminance profiles in the first direction and the luminance profiles in the second direction of multiple image forming position deviation detection patterns can be detected at high speed by an extremely simple composition wherein a plurality of photosensitive portions are disposed in a single pixel.

This invention's multiple image forming device comprises a plurality of image forming units, respectively forming different images for forming a multiple image, and the above-described image density detecting device, and wherein the densities of the images, respectively formed by the image forming units, are detected by means of the image density detecting device.

Since this invention's multiple image forming device is equipped with the above-described image density detecting device, the luminance profiles in the first direction and the luminance profiles in the second direction of image density detection patterns can be detected at high speed by an extremely simple composition wherein a plurality of photosensitive portions are disposed in a single pixel.

### Brief Description of the Drawings

FIG. 1 is a schematic composition diagram of a multiple image forming device of an embodiment.

FIG. 2 is a schematic composition diagram of a multiple image forming position deviation detecting device, included in the multiple image forming device of the embodiment.

FIG. 3 is a diagram for describing the detection, by means of the multiple image forming position deviation detecting device shown in FIG. 2, of positioning mark images that are formed on a transfer belt as multiple image forming position detection patterns.

FIG. 4 is a diagram for describing the detection, by means of the multiple image forming position deviation detecting device shown in FIG. 2, of gradated density detection patterns formed on the transfer belt.

FIG. 5 is a conceptual composition diagram of a photodetecting unit included in the multiple image forming position deviation detecting device shown in FIG. 2.

FIG. 6 is an enlarged plan view of the principal parts of an example of a photosensitive region included in the photodetecting unit shown in FIG. 5.

FIG. 7 is a sectional view taken on line VII-VII of FIG. 6.

FIG. 8 is an enlarged plan view of the principal parts of an example of a photosensitive region included in the photodetecting unit shown in FIG. 5.

FIG. 9 is an enlarged plan view of the principal parts of an example of a photosensitive region included in the photodetecting unit shown in FIG. 5.

FIG. 10 is an enlarged plan view of the principal parts of an example of a photosensitive region included in the photodetecting unit shown in FIG. 5.

FIG. 11 is an enlarged plan view of the principal parts of an example of a photosensitive region included in the photodetecting unit shown in FIG. 5.

FIG. 12 is an enlarged plan view of the principal parts of an example of a photosensitive region included in the photodetecting unit shown in FIG. 5.

FIG. 13 is a schematic composition diagram of a first signal processing circuit included in the photodetecting unit shown in FIG. 5.

FIG 14 is a schematic composition diagram of a second signal processing circuit included in the photodetecting unit shown in FIG. 5.

FIG. 15A is a graph showing the variation with time of a start signal that is input into a first shift register.

FIG 15B is a graph showing the variation with time of a signal that is input into the first shift register.

FIG. 15C is a graph showing the variation with time of a signal that is input into the first shift register.

FIG. 15D is a graph showing the variation with time of a reset signal that is input into a first integration circuit.

FIG. 15E is a graph showing the variation with time of a signal that is output from the first shift register.

FIG. 15F is a graph showing the variation with time of a signal that is output from the first shift register.

FIG. 15G is a graph showing the variation with time of a signal that is output from the first shift register.

FIG 15H is a graph showing the variation with time of a signal that is output from the first shift register.

FIG. 15I is a graph showing the variation with time of a voltage that is output from the first signal processing circuit.

FIG. 16A is a graph showing the variation with time of a start signal that is input into a second shift register.

FIG. 16B is a graph showing the variation with time of a signal that is input into the second shift register.

FIG. 16C is a graph showing the variation with time of a signal that is input into the second shift register.

FIG. 16D is a graph showing the variation with time of a reset signal that is input into a second integration circuit.

FIG. 16E is a graph showing the variation with time of a signal that is output from the second shift register.

FIG. 16F is a graph showing the variation with time of a signal that is output from the second shift register.

FIG. 16G is a graph showing the variation with time of a signal that is output from the second shift register.

FIG. 16H is a graph showing the variation with time of a signal that is output from the second shift register.

FIG. 16I is a graph showing the variation with time of a voltage that is output from the second signal processing circuit.

FIG. 17A is a diagram of a positioning mark that is a multiple image forming position deviation detection pattern.

FIG. 17B is a line diagram for describing an output from the first signal processing circuit.

FIG. 17C is a line diagram for describing an output from the second signal processing circuit.

FIG. 18 is a conceptual composition diagram of a modification example of a photodetecting unit included in the multiple image forming position deviation detecting device shown in FIG. 2.

### Best Modes for Carrying Out the Invention

An embodiment of this invention shall now be described with reference to the drawings. In the description, the same symbol shall be used for the same elements or elements having the same function and redundant description shall be omitted. In the following, each of parameters M and N shall be an integer no less than 2. Also, unless stated otherwise, parameter m shall be an arbitrary integer no less than 1 and no more than M, and parameter n shall be an arbitrary integer no less than 1 and no more than N.

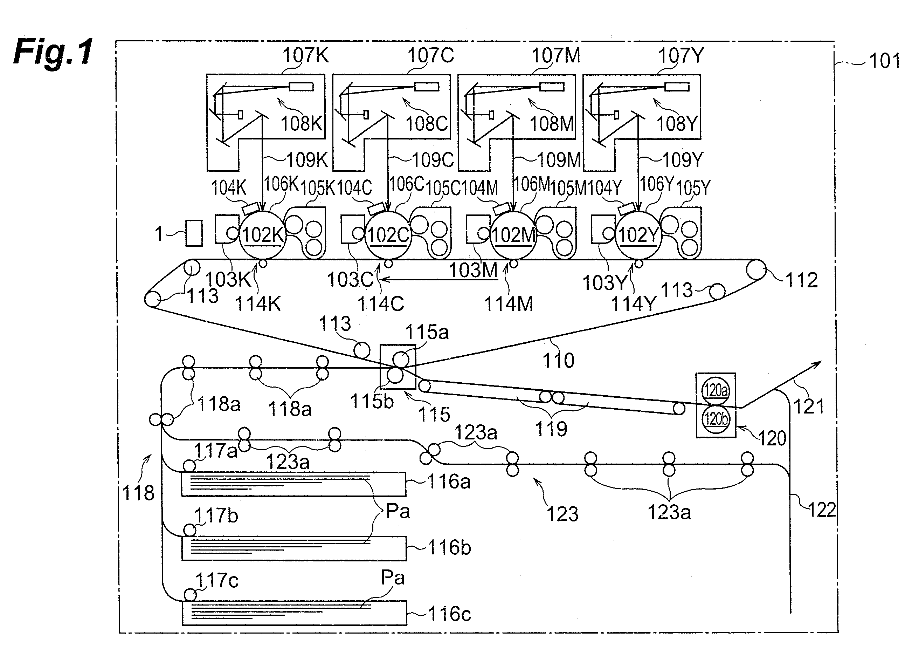

FIG. 1 is a schematic composition diagram showing a multiple image forming device of an embodiment and corresponds, for example, to a case of application of the present invention to a four-drum type color laser beam printer. The multiple image forming device of the present embodiment includes a multiple image forming position deviation detecting device and an image density detecting device, which are embodiments of this invention.

A color laser printer 101 (multiple image forming device) is equipped with a yellow image forming station 102Y, a magenta image forming station 102M, a cyan image forming station 102C, and a black image forming station 102K.

The yellow image forming station 102Y comprises a cleaner 103Y, a charger 104Y, a developing unit 105Y, and a photoconductor drum 106Y, which serves as an image carrier. A yellow exposure unit 107Y, for forming a latent image, is provided for the photoconductor drum 106Y. The yellow exposure unit 107Y has a laser scanning means 108Y that emits a scanning beam 109Y, which is pulse width modulated based on image signals, onto the photoconductor drum 106Y. A transfer belt 110 is spanned across a drive roller 112, which is driven to rotate by a drive motor (not shown), and a driven roller 113 and is moved by the rotation of the drive roller 112. A yellow transfer unit 114Y is disposed at a position opposite the photoconductor drum 106Y and across the transfer belt 110. The Yellow transfer unit 114Y transfers an image, formed of a yellow image recording material and developed on the photoconductor 106Y by the yellow image forming station 102Y, onto the photoconductor drum 106Y. Here, the yellow image forming station 102Y, the yellow exposure unit 107Y, and the yellow transfer unit 114Y make up a yellow image forming unit.

The magenta image forming station 102M comprises a cleaner 103M, a charger 104M, a developing unit 105M, and a photoconductor drum 106M, which serves as an image carrier. A magenta exposure unit 107M, for forming a latent image, is provided for the photoconductor drum 106M. The magenta exposure unit 107M has a laser scanning means 108M that emits a scanning beam 109M, which is pulse width modulated based on image signals, onto the photoconductor drum 106M. A magenta transfer unit 114M is disposed at a position opposite the photoconductor drum 106M and across the transfer belt 110. The magenta transfer unit 114M transfers an image, formed of a magenta image recording material and developed on the photoconductor 106M by the magenta image forming station 102M, onto the photoconductor drum 106M. Here, the magenta image forming station 102M, the magenta exposure unit 107M, and the magenta transfer unit 114M make up a magenta image forming unit.

The cyan image forming station 102C comprises a cleaner 103C, a charger 104C, a developing unit 105C, and a photoconductor drum 106C, which serves as an image carrier. A cyan exposure unit 107C, for forming a latent image, is provided for the photoconductor drum 106C. A cyan exposure unit 107C has a laser scanning means 108C that emits a scanning beam 109C, which is pulse width modulated based on image signals, onto the photoconductor drum 106C. A cyan transfer unit 114C is disposed at a position opposite the photoconductor drum 106C and across the transfer belt 110. The cyan transfer unit 114C transfers an image, formed of a cyan image recording material and developed on the photoconductor 106C by the cyan image forming station 102C, onto the photoconductor drum 106C. Here, the cyan image forming station 102C, the cyan exposure unit 107C, and the cyan transfer unit 114C make up a cyan image forming unit.

The Black image forming station 102K comprises a cleaner 103K, a charger 104K, a developing unit 105K, and a photoconductor drum 106, which serves as an image carrier. A black exposure unit 107K, for forming a latent image, is provided for the photoconductor drum 106K. The Black exposure unit 107K has a laser scanning means 108K that emits a scanning beam 109K, which is pulse width modulated based on image signals, onto the photoconductor drum 106K. A black transfer unit 114K is disposed at a position opposite the photoconductor drum 106K and across the transfer belt 110. The Black transfer unit 114K transfers an image, formed of a black image recording material and developed on the photoconductor 106K by the black image forming station 102K, onto the photoconductor drum 106K. Here, the black image forming station 102K, the black exposure unit 107K, and the black transfer unit 114K make up a black image forming unit.

A transfer paper transferring unit 115 is disposed along the conveying path of the transfer belt 110 at a position below the respective image forming stations 102Y, 102M, 102C, and 102K. The Transfer paper transferring unit 115 has a set of the transfer rollers 115a and 115b, which sandwich the transfer belt 110, and transfers the respective color images, which have been transferred onto the transfer belt 110, onto a transfer paper.

The transfer papers Pa, which are sheets of paper, are housed in a plurality of cassettes 116a, 116b, and 116c and are raised by springs so that transfer papers Pa at the upper surface side are respectively put in contact with pickup rollers 117a, 117b, and 117c. Each paper Pa that has been separated by the pickup roller 117a, 117b, or 117c is conveyed along a conveying path 118 in the direction in which the transfer paper transferring unit 115 is disposed. Conveying rollers 118a are disposed at predetermined intervals along the conveying path 118. The transfer paper Pa, onto which the respective color images have been transferred by the transfer paper transfer unit 115, is conveyed by a conveyor belt 119 to a fixing unit 120. The fixing unit 120 comprises a heat fixing roller 120a and press roller 120b and fixes, by heat fusion, the respective color images (toner images), which have been transferred onto the transfer paper Pa.

The transfer paper Pa, onto which the respective color images have been fixed by fixing unit 120, is moved along a ejection conveying path 121 and is ejected out of the color laser printer 101. A transfer paper inversion conveying path 122, for inverting the transfer paper for printing on the back surface, is branched from an intermediate portion of the ejection conveying path 121. A conveying path 123 branches from the transfer paper inversion conveying path 122, and the conveying path 123 is arranged to be connected to an intermediate portion of the conveying path 118. Conveying rollers 123a are positioned at predetermined intervals along the conveying path 123.

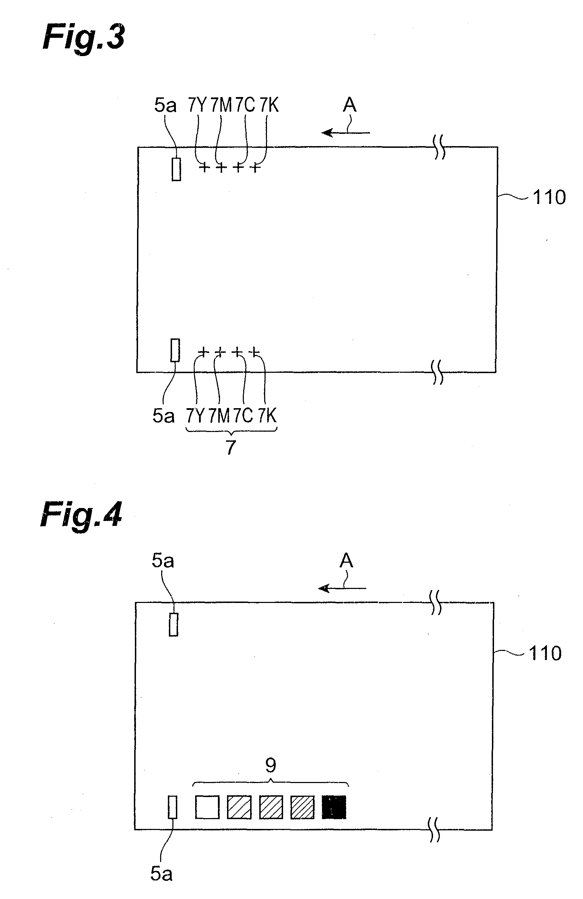

With the color laser beam printer 101, having the color image forming stations 102Y, 102M, 102C, and 102K, in the process of forming an image, positioning mark images 7, which serve as multiple image forming position deviation detection patterns, are formed for the respective colors of yellow, magenta, cyan, and black by the Carlson process or other predetermined process at both ends of the respective color image forming portions corresponding to the respective colors of yellow (Y), magenta (M), cyan (C), and black (K) (as shown in FIG. 3, the positioning mark images that are formed for the respective colors shall be referred to by the symbols, 7Y, 7M, 7C, and 7K, respectively) and are transferred successively onto the transfer belt 110.

As shown in FIG. 3, on the transfer belt 110, the positioning mark images 7, which are formed at both ends of the respective color image forming portions are transferred in a direction orthogonal to the conveying direction of the transfer belt 110, that is, at the right end and the left end of the respective image forming portions and, in order to prevent the mixing of colors, the transfer positions are shifted in the direction of conveying of the transfer belt 110, that is, in the subscan direction (direction of arrow A in the FIGURE) in the order of yellow, magenta, cyan, and black.

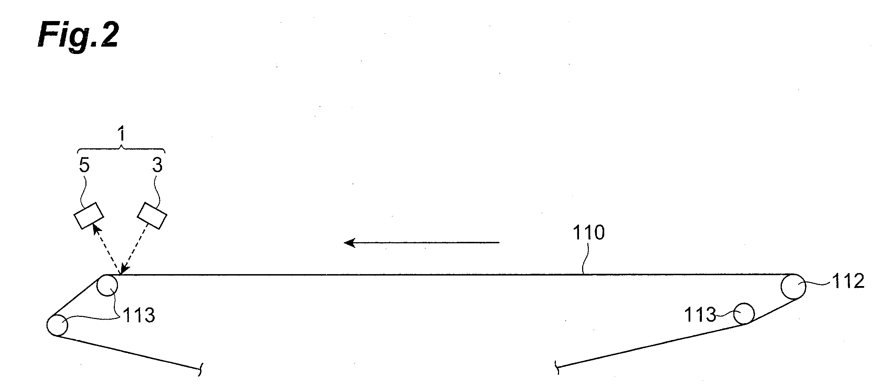

As shown in FIG. 2, on the transfer belt 110, the positioning mark images 7, which have been transferred onto the right ends and the left ends of the respective image forming portions, are detected by a multiple image forming position deviation detecting device 1, which is positioned in correspondence to the respective mark images to detect the mark images. This multiple image forming position deviation detecting device 1 comprises a light emitting unit 3, having a light emitting element, and a photodetecting unit (photodetecting means) 5, serving as a positioning mark image detecting unit.

The detection of the positioning mark images 7 is carried out as follows. That is, when the positioning mark images 7 are conveyed along with the transfer belt 110 and reach the positioning mark detection regions 5a of the photodetecting unit 5 as shown in FIG. 3, the light emitting unit 3 (light emitting element), which is positioned slightly above the transfer belt 110, is actuated by the actuation of a positioning mark image detecting means (not shown), and the light from the light emitting unit 3 (light emitting element) is reflected by each positioning mark image 7 on the transfer belt 110 and this reflected light is detected by the photodetecting unit 5.

In this process, the detection of the positioning mark image 7 is preferably carried out in an infrared range (750 to 950nm) in order to detect the respective positioning mark images, drawn on the transfer unit 110 using the respective toners of the four colors (yellow, magenta, cyan, and black), at the same sensitivity as much as possible. Since the transfer belt 110 is transparent, there is hardly any incidence of light besides those from the positioning mark images 7.

The reflected light that is thus detected by the photodetecting unit 5 is input and processed by a CPU (central processing unit) and by the CPU (central processing unit), the positions of the positioning mark images 7 are determined and the registration deviation amounts are computed. Here, if the transfer position of the positioning mark image 7 is known and the CPU (central processing unit) judges that registration is set accurately, transfer onto this known transfer position is carried out. Oppositely, if the CPU (central processing unit) judges that registration has degraded, the CPU (central processing unit) determines the deviation amount by computing the error between the known value and the position onto which the positioning mark image 7 has actually been transferred.

In accordance to this deviation amount, reflection mirrors in the laser beam path of the above-mentioned laser scanning means 108Y, 108M, 108C, and 108K are actuated using a stepping motor (not shown) and the magnification, tilting in the subscan direction, parallel movement, etc., are adjusted to correct the registration. In addition, the registration deviation amount may also be corrected by controlling the driving of the photoconductor drum and the transfer belt. Also besides the above, the registration deviation amount may be corrected by moving the relative positions of the transfer belt 110 and the transfer paper transfer unit 115 in the main scan direction near the transfer paper transfer unit 115.

This registration correction is performed using one of the above-described color image forming stations 102Y, 102M, 102C, and 102K as a reference image forming station, not performing any correction whatsoever in regard to this reference image forming station, and matching the other three image forming stations to the reference image forming station.

Here, the positioning mark images 7 enable detection of deviation in two directions at once. In the present embodiment, each positioning mark image 7 has a "+" shape (cross shape) as shown in FIG. 3. Besides this, the positioning mark image 7 may have a "double circle shape," a "T" shape, a "◇" shape, a "●" shape, etc. Also, the positioning mark images on the transfer belt that have been read for image formation of a desired color are removed from the transfer belt 110 by the actuation of a belt cleaner blade (not shown) to enable subsequent image forming.

The reading (detection) of density detection patterns, which are formed on the transfer belt 110, shall now be described with reference to FIG. 4.

This detection of density detection patterns is performed separately from the positioning mark image detection for registration correction. As shown in FIG. 4, in regard to the printing of a density detection pattern 9, the density detection pattern 9, having uniform-density patches of different gradations, are formed according to each color by printing density patches of several gradations, formed by the Carlson process or other predetermined process, at positions on the transfer belt 110 at both or either of the left and right ends of the transfer belt 110 that are spaced apart by a certain interval and are within the range of a region equal to or wider than the detection region 5a of multiple image forming position deviation detecting device 1, that is, the photodetecting unit 5, which serves both as a density detection pattern detecting unit and as the positioning mark image detecting unit. Multiple image forming position deviation detecting device 1 thus functions as an image density detecting device for detecting the densities of images.

The transfer of the density detection pattern 9, having density patches of several gradations, onto the transfer belt 110 is performed one color at a time at suitable intervals on the transfer belt 110 for each of the colors, yellow, magenta, cyan, and black. For each color, the density detection pattern 9 is transferred onto either or both of the left and right ends of the transfer belt 110. Each density detection pattern 9 that has been formed on the transfer belt 110 is cleaned by a belt cleaner (not shown) after detection of the density patches of the density detection pattern 9 by photodetecting unit 5.

The output values concerning each density detection pattern that has been detected are converted into image densities based on a priorly measured relationship between the output of the photodetecting unit 5 and image density and the gradation property of the current image can thereby be made known to perform density control. Also, by simultaneously measuring the surface potentials at positions corresponding to the density patches of each density detection pattern on the photoconductor drum, V-D characteristics, which are important in terms of the density characteristics of an image, can be ascertained and used as basic data for controlling image densities, and by determining appropriate contrast potentials from the V-D characteristics and varying the laser power, grid bias, developing bias, etc., density control of the image is performed.

The above-described registration correction and image density control are separate operations, and the timings at which the respective operations are performed are set so that by the registration correction, the registration deviation amounts of the respective colors will constantly fall within a priorly determined range and by the image density control, the density or gradation properties of the images of the respective colors will be maintained at fixed levels. The printing operation is thus carried out in a state in which transfer deviation is eliminated by registration correction and the density and gradation properties of the images of the respective colors are maintained appropriately by the image density control.

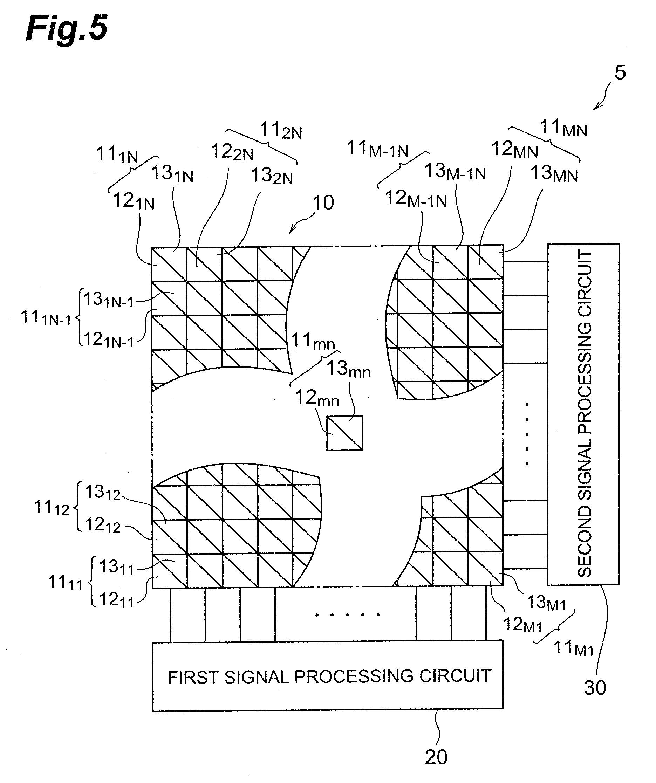

The above-described photodetecting unit 5 shall now be described in detail with reference to FIGS. 5 to 17. FIG. 5 is a conceptual composition diagram of a photodetecting device of the present embodiment. As shown in FIG. 5, the photodetecting unit 5 comprises a photosensitive region 10, a first signal processing circuit 20, and a second signal processing circuit 30.

In the photosensitive region 10, pixels 11ₘₙ are arrayed two-dimensionally in M rows and N columns. One pixel is arranged by adjacently positioning, in the same plane, a photosensitive portion 12ₘₙ (first photosensitive portion) and a photosensitive portion 13ₘₙ (second photosensitive portion), each outputting a current that is in accordance with the intensity of light that is made incident thereon. Thus in the photosensitive region 10, the photosensitive portions 12ₘₙ and the photosensitive portions 13ₘₙ are arrayed in a two-dimensionally mixed manner in the same plane.

Across each of the pluralities of pixels 11₁₁ to 11_{1N}, 11₂₁ to 11_{2N}, ···, 11_{M1} to 11_{MN}, aligned in a first direction in the two-dimensional array, the photosensitive portion 12ₘₙ among the plurality of photosensitive portions 12ₘₙ and 13ₘₙ making up each corresponding the pixel 11ₘₙ is electrically connected to the same photosensitive portion 12ₘₙ of each of the other corresponding pixels (that is, for example, the photosensitive portions 12₁₁ to 12_{1N} are electrically connected to each other). Also across each of the pluralities of pixels 11₁₁ to 11_{M1}, 11₁₂ to 11_{M2}, ···, 11_{1N} to 11_{MN}, aligned in a second direction in the two-dimensional array, the photosensitive portion 13ₘₙ among the plurality of photosensitive portions 12ₘₙ and 13ₘₙ making up each corresponding the pixel 11ₘₙ is electrically connected to the same photosensitive portion 13ₘₙ of each of the other corresponding pixels (that is, for example, the photosensitive portions 13₁₁ to 13_{M1} are electrically connected to each other).

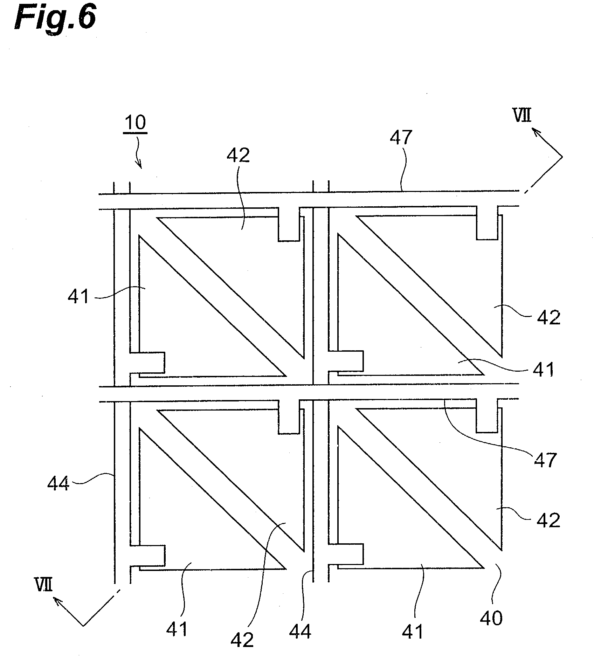

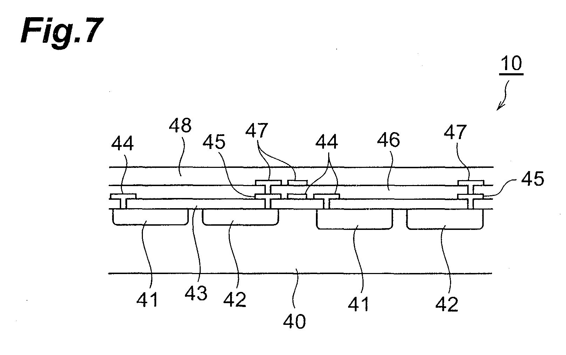

The composition of the photosensitive region 10 shall now be described based on FIGS. 6 and 7. FIG. 6 is an enlarged plan view of the principal parts of an example of the photosensitive region, and FIG. 7 is a sectional view taken on line VII-VII. In FIG. 6, the illustration of a protective layer 48 is omitted.

The photosensitive region 10 comprises a semiconductor substrate 40, formed of a P-type (first conductive type) semiconductor, and N-type (second conductive type) semiconductor regions 41 and 42, formed on the top surface of the semiconductor substrate 40. The photosensitive portions 12ₘₙ and 13ₘₙ are thus arranged as photodiodes comprising the semiconductor substrate 40 portions and the pair of second conductive type semiconductor regions 41 and 42. As shown in FIG. 6, each of the second conductive type semiconductor regions 41 and 42 has a substantially triangular shape as viewed from the light-incident direction, and in a single pixel, the two regions 41 and 42 are formed with one side of each being mutually adjacent. The semiconductor substrate 40 is set to the ground potential. The photosensitive region 10 may instead comprise a semiconductor substrate, formed of an N-type semiconductor, and P-type semiconductor regions, formed on the top surface of the semiconductor substrate. As can be understood from FIG. 6, the regions 41 (the photosensitive portions 12ₘₙ) and the regions 42 (the photosensitive portions 13ₘₙ) are aligned alternately in the first direction and the second direction. The regions 41 (the photosensitive portions 12ₘₙ) and the regions 42 (the photosensitive portions 13ₘₙ) are also aligned alternately in a third direction and a fourth direction that intersect the first direction and the second direction (for example, at an angle of 45°).

A first insulating layer 43 is formed on the semiconductor substrate 40 and the regions 41 and 42, and via contact holes formed in the first insulating layer 43, first wirings 44 are electrically connected to the regions 41. Also via contact holes formed in the first insulating layer 43, electrodes 45 are electrically connected to the regions 42.

A second insulating layer 46 is formed on the first insulating layer 43, and via contact holes formed in the second insulating layer 46, second wirings 47 are electrically connected to electrodes 45. The regions 42 are thus electrically connected to the second wirings 47 via the electrodes 45.

A protective layer 48 is formed on the second insulating layer 46. The first insulating layer 43, the second insulating layer 46, and the protective layer 48 are formed of SiO₂ or SiN, etc. The first wirings 44, the electrodes 45, and the second wirings 47 are formed of Al or other metal.

Each of the first wirings 44 electrically connects the regions 41 in the respective pixels 11ₘₙ across the first direction and is disposed so as to extend between pixels 11ₘₙ in the first direction. By thus connecting the regions 41 in the respective pixels 11ₘₙ by the first wirings 44, the photosensitive portions 12ₘₙ (for example, the photosensitive portions 12₁₁ to 12_{1N}) are electrically connected to each other across each of the pluralities of the pixels 11₁₁ to 11_{1N}, 11₂₁ to 11_{2N}, ···, 11_{M1} to 11_{MN} that are aligned in the first direction in the two-dimensional array, thus forming long photosensitive units that extend in the first direction in the photosensitive region 10. M columns of these long photosensitive units that extend in the first direction are thus formed.

Each of the second wirings 47 electrically connects the regions 42 in the respective pixels 11ₘₙ across the second direction and is disposed so as to extend between pixels 11ₘₙ in the second direction. By thus connecting the other regions 42 in the respective pixels 11ₘₙ by the second wirings 47, the photosensitive portions 13ₘₙ (for example, the photosensitive portions 13₁₁ to 13_{M1}) are electrically connected to each other across each of the pluralities of pixels 11₁₁ to 11_{M1}, 11₁₂ to 11_{M2}, ···, 11_{1N} to 11_{MN} that are aligned in the second direction in the two-dimensional array, thus forming long photosensitive units that extend in the second direction in the photosensitive region 10. N rows of these long photosensitive units that extend in the second direction are thus formed.

In the photosensitive region 10, the above-mentioned M columns of long photosensitive units that extend in the first direction and the N rows of long photosensitive units that extend in the second direction are formed on the same plane.

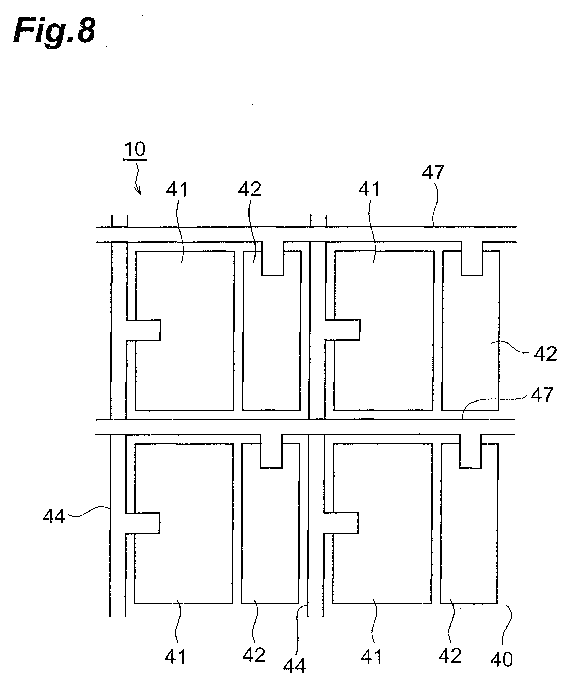

The shapes of the regions 41 and 42 are not limited to the substantially triangular shapes shown in FIG 6 and may be other shapes as shown in FIGS. 8 to 12.

The second conductive type semiconductor regions (photosensitive portions) shown in FIG. 8 have rectangular shapes as viewed from the light-incident direction, and in a single pixel, the two regions 41 and 42 are formed with a long side of each being mutually adjacent. The regions 41 (the photosensitive portions 12ₘₙ) and the regions 42 (the photosensitive portions 13ₘₙ) are aligned alternately in the second direction. As shown in FIG. 8, even though in each pixel, the second conductive semiconductor regions of the first direction and the second direction differ in area, it is sufficient that in each direction, the areas are fixed among the pixels. That is, it is sufficient that the total areas of the mutually connected photosensitive regions be the same for all wirings that extend in the same direction.

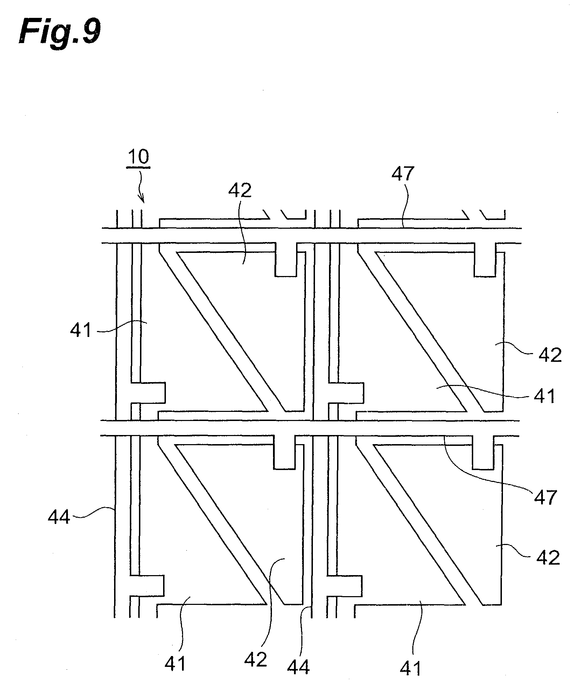

With the second conductive type semiconductor regions (photosensitive portions) shown in FIG. 9, the regions 41, each with a substantially triangular shape, are formed to be continuous in the first direction. Each of the regions 42 has a substantially triangular shape and is formed independently of each other across the pixels 11ₘₙ. The regions 41 (the photosensitive portions 12ₘₙ) and the regions 42 (the photosensitive portions 13ₘₙ) are aligned alternately in the second direction. Though in the case where the regions 41 are formed to be continuous in the first direction, the provision of the first wirings 44 is not necessarily required, since the reading speed may drop in accompaniment with an increase in serial resistance, the regions 41 are preferably connected electrically by the first wirings 44.

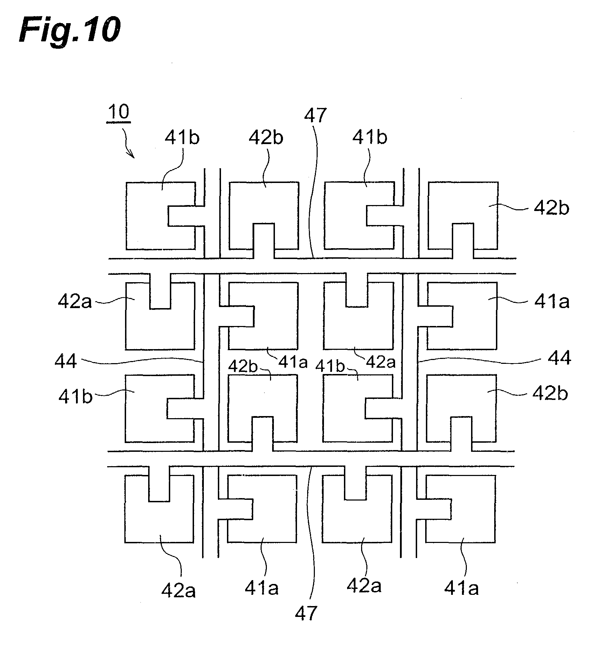

With the second conductive type semiconductor regions (photosensitive portions) shown in FIG. 10, each pixel comprises the four regions 41a, 41b, 42a, and 42b and diagonally positioned regions are electrically connected as a pair by the first wiring 44 or the second wiring 47. The regions 41 (the photosensitive portions 12ₘₙ) and the regions 42 (the photosensitive portions 13ₘₙ) are aligned alternately in the first direction and the second direction. The regions 41 (the photosensitive portions 12ₘₙ) and the regions 42 (the photosensitive portions 13ₘₙ) are also aligned alternately in a third direction and a fourth direction.

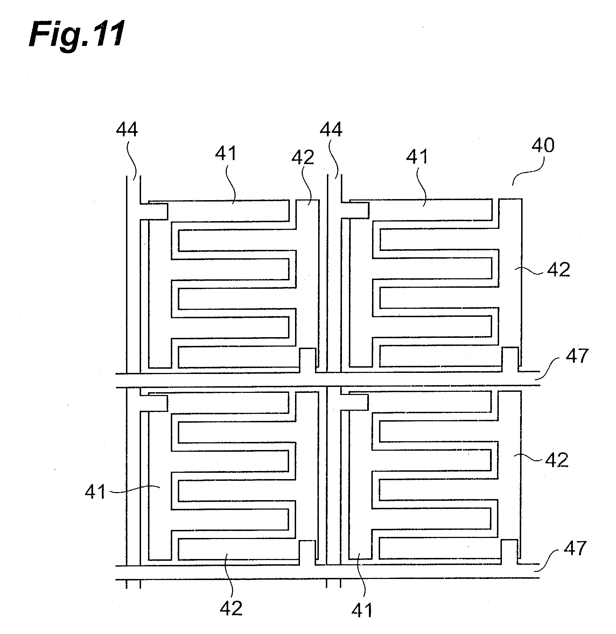

With the second conductive semiconductor regions (photosensitive portions), shown in FIG 11, two pectinate regions 41 and 42 are formed in a mutually engaged manner.

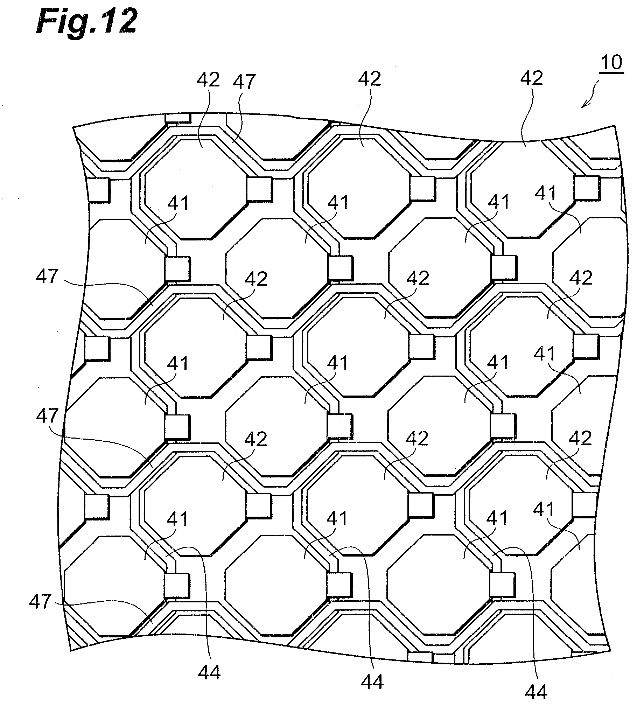

Each of the second conductive type semiconductor regions (photosensitive portions) shown in FIG. 12 has a polygonal shape (for example, an octagonal shape) with no less than four sides as viewed from the light-incident direction, and in one pixel, the regions are formed with one side of each being mutually adjacent. In one pixel, the region 41 and the region 42 are positioned along a third direction that intersects the first direction and the second direction and, as viewed from the light-incident side, are arrayed in honeycomb-like manner. The regions 41 (the photosensitive portions 12ₘₙ) and the regions 42 (the photosensitive portions 13ₘₙ) are thus aligned alternately in the third direction and a fourth direction.

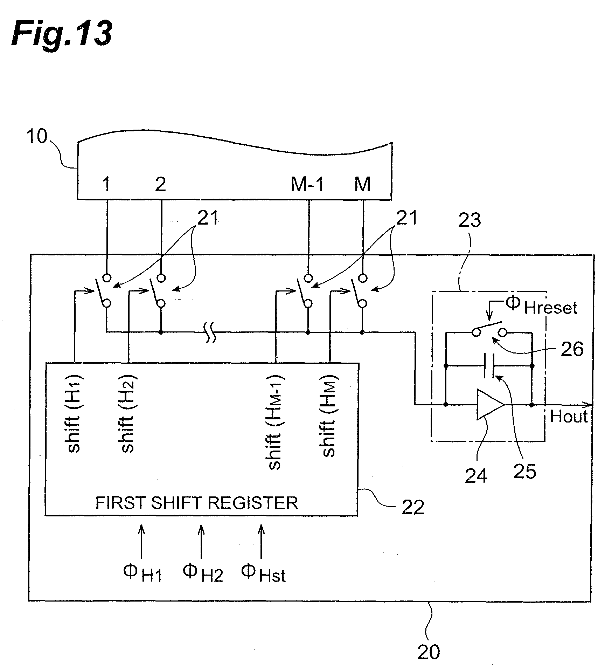

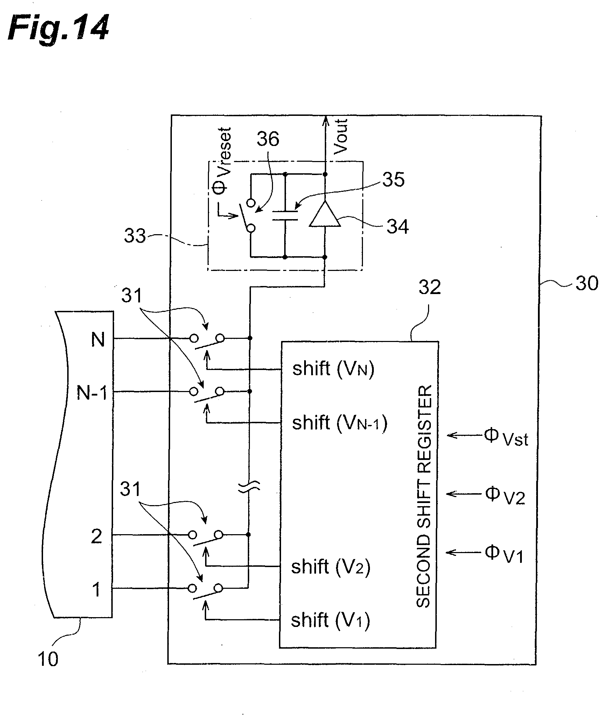

The compositions of the first signal processing circuit 20 and the second signal processing circuit 30 shall now be described based on FIGS. 13 and 14. FIG. 13 is a schematic composition diagram of the first signal processing circuit, and FIG. 14 is a schematic composition diagram of the second signal processing circuit.

The first signal processing circuit 20 outputs a voltage Hₒᵤₜ that indicates a luminous profile in the second direction of incident light to the photosensitive region 10. The second signal processing circuit 30 outputs a voltage Vₒᵤₜ that indicates a luminous profile in the first direction of incident light to the photosensitive region 10. The first and second signal processing circuits 20 and 30 may be operated simultaneously or individually in a time-series order.

As shown in Fig. 13, the first signal processing circuit 20 includes first switches 21, a first shift register 22, and a first integrating circuit 23. The first switches 21 are provided corresponding to each relevant group of the photosensitive portions 12ₘₙ, which are electrically connected across the pluralities of the pixels 11₁₁ to 11_{1N}, 11₂₁ to 11_{2N}, ···, 11_{M1} to 11_{MN} aligned in the first direction (the M columns of long photosensitive units that extend in the first direction and comprise the second conductive type semiconductor regions 41) The first shift register 22 sequentially reads, in the second direction, the currents from the photosensitive portions 12ₘₙ, which are electrically connected across the pluralities of the pixels 11₁₁ to 11_{1N}, 11₂₁ to 11_{2N}, ···, 11_{M1} to 11_{MN} aligned in the first direction. The first integrating circuits 23 sequentially receive the currents, which are from each group of the photosensitive portions 12ₘₙ, which are electrically connected across the pluralities of the pixels 11₁₁ to 11_{1N}, 11₂₁ to 11_{2N}, ···, 11_{M1} to 11_{MN} aligned in the first direction and are sequentially connected by the first shift register 22. Then, the first integrating circuit 23 converts the current into voltage and outputs the voltage.

The first switches 21 are controlled by a signals shift(Hₘ) outputted from the first shift register 22, and then are sequentially closed. Electric charges are accumulated in the group of photosensitive portions 12ₘₙ, which are electrically connected across the plurality of pixels 11₁₁ to 11_{1N}, 11₂₁ to 11_{2N}, ···, and 11_{M1} to 11_{MN} arrayed in the first direction. By closing the first switches 21, the above accumulated electric charges are changed into electric currents, which are then outputted to the first integrating circuit 23 through the first wires 44 and the first switches 21. Operations of the first shift register 22 are controlled by signals Φ_{H1}, Φ_{H2} and Φ_{Hst} outputted from a control circuit (not shown), thus closing the first switches 21 sequentially.

The first integrating circuit 23 is inputted the electric currents from the groups of photosensitive portions 12ₘₙ, which are electrically connected across the plurality of pixels 11₁₁ to 11_{1N}, 11₂₁ to 11_{2N}, ···, and 11_{M1} to 11_{MN} arrayed in the first direction. The first integrating circuit 23 includes an amplifier 24, a capacitor 25, and a switch 26. The amplifier 24 amplifies electric charges of the electric currents that inputs to the first integrating circuit 23. In the capacitor 25, one terminal thereof is connected to an input terminal of the amplifier 24, and the other terminal thereof is connected to an output terminal of the amplifier 24. In the switch 26, one terminal thereof is connected to the input terminal of the amplifier 24, and the other terminal thereof is connected to the output terminal of the amplifier 24. The switch 26 is turned to an "ON" state when a reset signal Φ_{Hreset} outputted from the control circuit is "High," and is turned to an "OFF" state when the reset signal Φ_{Hreset} is "Low."

When the switch 26 is in the "ON" state, the first integrating circuit 23 discharges the charge of the capacitor 25, and initializes it. On the other hand, when the switch 26 is in the "OFF" state, the first integrating circuit 23 accumulates the electric charges in the capacitor 25. These electric charges have been inputted to the input terminal from the groups of photosensitive portions 12ₘₙ, which are electrically connected across the plurality of pixels 11₁₁ to 11_{1N}, 11₂₁ to 11_{2N}, ···, and 11_{M1} to 11_{MN} arrayed in the first direction. Thereafter, the first integrating circuit 23 outputs voltages Hₒᵤₜ corresponding to the above-mentioned accumulated electric charges.

As shown in Fig. 14, the second signal processing circuit 30 includes second switches 31, a second shift register 32, and a second integrating circuit 33. The second switches 31 are provided corresponding to each relevant group of the photosensitive portions 13ₘₙ, which are electrically connected across the pluralities of the pixels 11₁₁ to 11_{M1}, 11₁₂ to 11_{M2}, ···, 11_{1N} to 11_{MN} aligned in the second direction (the N rows of long photosensitive units that extend in the second direction and comprise the second conductive type semiconductor regions 42) The second shift register 32 sequentially reads, in the first direction, the currents from the photosensitive portions 13ₘₙ, which are electrically connected across the pluralities of the pixels 11₁₁ to 11_{M1}, 11₁₂ to 11_{M2}, ···, 11_{1N} to 11_{MN} aligned in the second direction. The second integrating circuits 33 sequentially receive the currents, which are from each group of the photosensitive portions 13ₘₙ, which are electrically connected across the pluralities of the pixels 11₁₁ to 11_{M1}, 11₁₂ to 11_{M2}, ···, 11_{1N} to 11_{MN} aligned in the second direction and are sequentially connected by the second shift register 32. Then, the second integrating circuit 33 converts the current into voltage and outputs the voltage.

The second switches 31 are controlled by a signals shift(Vₙ) outputted from the second shift register 32, and then are sequentially closed. Electric charges are accumulated in the groups of photosensitive portions 13ₘₙ, which are electrically connected across the plurality of pixels 11₁₁ to 11_{M1}, 11₁₂ to 11_{M2}, ···, and 11_{1N} to 11_{MN} arrayed in the second direction. By closing the second switches 31, the above accumulated electric charges are changed into electric currents, which are then inputted to the second integrating circuit 33 through the second wires 47 and the second switches 31. Operations of the second shift register 32 are controlled by signals Φ_{V1}, Φ_{V2} and Φ_{Vst} outputted from a control circuit (not shown), thus closing the second switches 31 sequentially.

The second integrating circuit 33 is inputted the electric currents from the groups of photosensitive portions 13ₘₙ, which are electrically connected across the plurality of pixels 11₁₁ to 11_{M1}, 11₁₂ to 11_{M2}, ···, and 11_{1N} to 11_{MN} arrayed in the second direction. The second integrating circuit 33 includes an amplifier 34, a capacitor 35, and a switch 36. The amplifier 34 amplifies electric charges of the electric currents that are inputted to the second integrating circuits 33. In the capacitor 35, one terminal thereof is connected to an input terminal of the amplifier 34, and the other terminal thereof is connected to an output terminal of the amplifier 34. In the switch 36, one terminal thereof is connected to the input terminal of the amplifier 34, and the other terminal thereof is connected to the output terminal of the amplifier 34. The switch 36 is turned to an "ON" state when a reset signal Φ_{Vreset} outputted from the control circuit is "High," and is turned to an "OFF" state when the reset signal Φ_{Vreset} is "Low."

When the switch 36 is in the "ON" state, the second integrating circuit 33 discharges the charge of the capacitor 35, and initializes it. On the other hand, when the switch 36 is in the "OFF" state, the second integrating circuit 33 accumulates the electric charges in the capacitor 35. These electric charges have been inputted to the input terminal from the groups of photosensitive portions 13ₘₙ, which are electrically connected across the plurality of pixels 11₁₁ to 11_{M1}, 11₁₂ to 11_{M2}, ···, and 11_{1N} to 11_{MN} arrayed in the second direction. Thereafter, the second integrating circuit 33 outputs voltages Vₒᵤₜ corresponding to the above-mentioned accumulated electric charges.

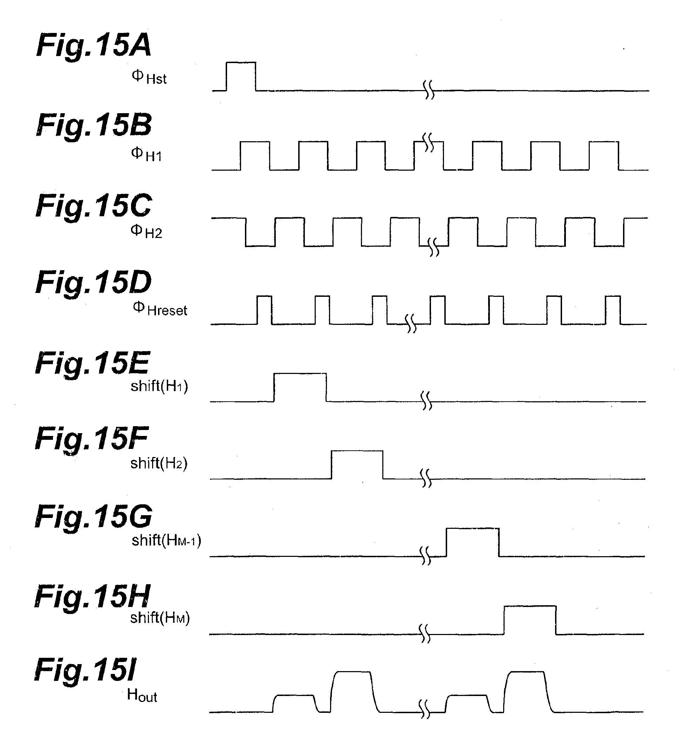

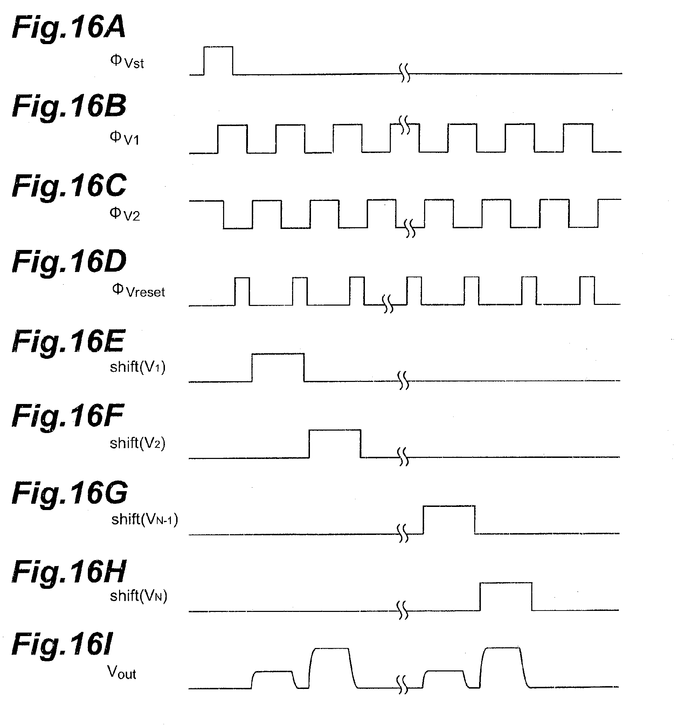

Hereinafter, operations of the first signal processing circuit 20 and the second signal processing circuit 30 shall now be described based on FIGS. 15A to 15I and 16A to 16I. FIGS. 15A to 15I are timing charts for describing the operations of the first signal processing circuit and FIGS. 16A to 16I are timing charts for describing the operations of the second signal processing circuit.

After the start signal Φ_{Hst} is inputted to the first shift register 22 from the control circuit (see Fig. 15A), signals shift(Hₘ), each having a pulse width corresponding to a duration from a rise of the signal Φ_{H2} to a fall of the signal Φ_{H1}, are sequentially outputted (see Figs. 15B and 15C, and Figs. 15E to 15H). When the first shift register 22 outputs the signal shift(Hₘ) to each of the corresponding first switches 21, the first switches 21 are sequentially closed. Thereafter, the electric charges accumulated in the corresponding group of photosensitive portions 12ₘₙ on one side are turned into electric currents and are sequentially inputted to the first integrating circuits 23.

The reset signal Φ_{Hreset} is inputted to the first integrating circuit 23 from the control circuit (see Fig. 15D). While the reset signal Φ_{Hreset} is in an "OFF" state, the electric charges accumulated in the corresponding group of photosensitive portions 12ₘₙ are accumulated in the capacitor 25. Then, voltages Hₒᵤₜ corresponding to amounts of the accumulated electric charges are sequentially outputted from the first integrating circuit 23 (see Fig. 15I). When the reset signal Φ_{Hreset} is in an "ON" state, the first integrating circuit 23 closes the switch 26 and reset the capacitor 25.

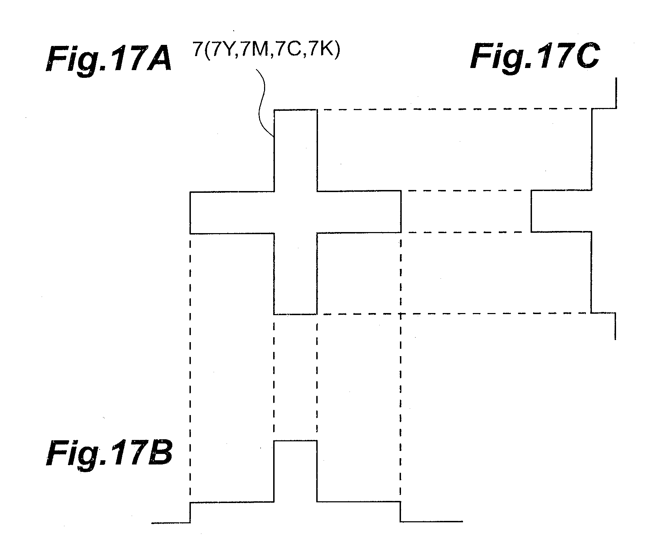

In this way, the first signal processing circuit 20 sequentially outputs the voltages Hₒᵤₜ as time-series data of each of the corresponding groups of photosensitive portions 12ₘₙ. The voltages Hₒᵤₜ correspond to the electric charges accumulated in the groups of photosensitive portions 12ₘₙ, which are electrically connected across the plurality of pixels 11₁₁ to 11_{1N}, 11₂₁ to 11_{2N},..., and 11_{M1} to 11_{MN} arrayed in the first direction. As shown in FIG. 17B, the time-series data indicates the luminance profile (the light intensity distribution) in the second direction of the light that is illuminated from the light emitting unit 3 (the light emitting element) and is reflected by the positioning mark image 7 (each of the mark images 7Y, 7M, 7C, and 7K). The luminance profile in the second direction of the reflected from the density detection pattern 9 is also detected in likewise manner. FIG. 17A shows the positioning mark image 7 (each of the mark images 7Y, 7M, 7C, and 7K).

After the start signal Φ_{Vst} is inputted to the second shift register 32 from the control circuit (see Fig. 16A), signals shifts (Vₙ), each having a pulse width corresponding to a duration from a rise of the signal Φ_{V2} to a fall of the signal Φ_{V1}, are sequentially outputted (see Figs. 16B and 16C, and Figs. 16E to 16H). When the second shift register 32 outputs the shift(Vₙ) to each of the corresponding second switches 31, the second switches 31 are sequentially closed. Thereafter, the electric charges accumulated in the corresponding group of photosensitive portions 13ₘₙ are turned into electric currents and sequentially inputted to the second integrating circuit 33.

The reset signal Φ_{Vreset} is inputted to the second integrating circuit 33 from the control circuit (see Fig. 16D). While the reset signal Φ_{Vreset} is in an "OFF" state, the electric charges accumulated in the corresponding group of photosensitive portions 13ₘₙ are accumulated in the capacitor 35. Then, voltages Vₒᵤₜ corresponding to amounts of the accumulated electric charges are sequentially outputted from the second integrating circuit 33 (see Fig. 16I). When the reset signal Φ_{Vreset} is in an "ON" state, the second integrating circuit 33 closes the switch 36 and resets the capacitor 35.

In this way, the second signal processing circuit 30 sequentially outputs the voltages Vₒᵤₜ as time-series data of each of the corresponding group of photosensitive portions 13ₘₙ on the other side. The voltages Vₒᵤₜ correspond to the electric charges accumulated in the groups of photosensitive portions 13ₘₙ, which are electrically connected across the plurality of pixels 11₁₁ to 11_{M1}, 11₁₂ to 11_{M2},..., and 11_{1N} to 11_{MN} arrayed in the second direction. As shown in FIG. 17C, this time-series data indicate the luminance profile (the light intensity distribution) in the first direction of the light that is illuminated from the light emitting unit 3 (the light emitting element) and is reflected by the positioning mark image 7 (each of the mark images 7Y, 7M, 7C, and 7K). The luminance profile in the first direction of the reflected from the density detection pattern 9 is also detected in likewise manner.

Thus, in the present embodiment, the light incident to one pixel 11ₘₙ is outputted as an electric current from each of the plurality of photosensitive portions 12ₘₙ and 13ₘₙ that constitutes the pixel 11ₘₙ. The electric current corresponds to the intensity of the light sensed by each of the photosensitive portions 12ₘₙ and 13ₘₙ. The photosensitive portions 12ₘₙ are electrically connected across the plurality of pixels 11₁₁ to 11_{1N}, 11₂₁ to 11_{2N},..., and 11_{M1} to 11_{MN} arrayed in the first direction in the two-dimensional array. Hence, the currents outputted from the photosensitive portions 12ₘₙ are transmitted in the first direction. On the other hand, the photosensitive portions 13ₘₙ are electrically connected across the plurality of pixels 11₁₁ to 11_{M1}, 11₁₂ to 11_{M2},..., and 11_{1N} to 11_{MN} arrayed in the second direction in the two-dimensional array. Hence, the currents outputted from the photosensitive portions 13ₘₙ are transmitted in the second direction. In this way, the currents outputted from the photosensitive portions 12ₘₙ are transmitted in the first direction, and the currents outputted from the photosensitive portions 13ₘₙ are transmitted in the second direction. Accordingly, the respective luminous profiles in the first and second directions can be obtained independently. As a result, fast detection of two-dimensional positions of the incident light becomes viable with an extremely simple structure in which the plurality of photosensitive portions 12ₘₙ and 13ₘₙ are arrayed in one pixel.

Further, in the present embodiment, each of the photosensitive portions 12ₘₙ and 13ₘₙ includes a portion of semiconductor substrate 40, and second conductive type semiconductor regions 41 and 42. Each of the second conductive type semiconductor regions 41 and 42 has rectangular shapes as viewed from the light-incident direction. The two regions 41 and 42 are formed with a long side of each being mutually adjacent in one pixel. Therefore, it is possible to suppress an area reduction of each photosensitive portions 12ₘₙ and 13ₘₙ (second conductive type semiconductor regions 41 and 42) when the plurality of photosensitive portions 12ₘₙ and 13ₘₙ are arrayed within one pixel.

Furthermore, in the present embodiment, each of the second conductive type semiconductor regions 41 and 42 has rectangular shapes as viewed from the light-incident direction. The two regions 41 and 42 are formed with a long side of each being mutually adjacent in one pixel. Therefore, it is possible to suppress an area reduction of each photosensitive portions 12ₘₙ and 13ₘₙ (second conductive type semiconductor regions 41 and 42), when the plurality of photosensitive portions 12ₘₙ and 13ₘₙ are arrayed within one pixel.

Moreover, in the present embodiment, each of the second conductive type semiconductor regions 41 and 42 has a polygonal with no less than four sides as viewed from the light-incident direction. The two regions 41 and 42 are formed with one side of each being mutually adjacent in one pixel. Therefore, it is possible to suppress an area reduction of each photosensitive portions 12ₘₙ and 13ₘₙ (second conductive type semiconductor regions 41 and 42), when the plurality of photosensitive portions 12ₘₙ and 13ₘₙ are arrayed within one pixel. In addition, the peripheral length of each of the photosensitive portions 12ₘₙ and 13ₘₙ becomes reduced with respect to the area, and the dark current per unit area becomes reduced. A rhomboid shape may be employed as a polygonal shape with no less than four sides.

In the present embodiment, the second conductive type semiconductor regions 41 and 42 are also placed in rows within one pixel in a third direction that intersects the first and second directions. With this type of configuration, in the groups of photosensitive portions 12ₘₙ and the photosensitive portions 13ₘₙ, the photosensitive portions 12ₘₙ and 13ₘₙ corresponding to each group of photosensitive portions 12ₘₙ and 13ₘₙ are concentrated at the center of the corresponding group of photosensitive portions. Therefore, resolution can be improved.

Furthermore, the second conductive type semiconductor regions 41 and 42 are arrayed in honeycomb-like form as viewed from the light-incident direction. The areas of the respective photosensitive portions 12ₘₙ and 13ₘₙ (the second conductive type semiconductor regions 41 and 42) can thus be further restrained from becoming reduced in disposing the plurality of photosensitive portions 12ₘₙ and 13ₘₙ in one pixel. Also, since the geometrical symmetry is high, non-uniformity due to positional deviation of a mask used for forming the second conductive type semiconductor regions 41 and 42 (the photosensitive portions 12ₘₙ and 13ₘₙ) can be restrained.

Moreover, in the present embodiment, the first wirings 44 are disposed to extend between the pixels 11ₘₙ in the first direction and the second wirings 47 are disposed to extend between the pixels 11ₘₙ in the second direction. The incidence of light onto the photosensitive portions 12ₘₙ and 13ₘₙ (the second conductive type semiconductor regions 41 and 42) will thus not be obstructed by the respective wirings 44 and 47 and the lowering of detection sensitivity can be restrained.

Moreover, in the present embodiment, the light detecting unit 5 has the first shift register 22, the second shift register 32, the first integration circuit 23, and the second integration circuit 33. The luminance profile in the first direction and the luminance profile in the second direction can thus be obtained with an extremely simple composition.

Moreover, in the present embodiment, just m + n times of data processing (m times of data processing in first signal processing circuit 20 and n times of data processing in second signal processing circuit 30) suffices for detecting the luminance profile in the first direction and the luminance profile in the second direction of the positioning mark image 7 or the density detection pattern 9, and in comparison with the m × n times of data processing that are required in the case of using a CCD image sensor with m × n pixels, the data processing amount is significantly reduced. Consequently, the signal processing times in the first signal processing circuit 20 and the second signal processing circuits 30 are short and the load placed on each of the signal processing circuits 20 and 30 is low.

Moreover, in the present embodiment, the color laser beam printer 101 (the multiple image forming device) is equipped with the above-described multiple image forming the position deviation detecting device 1 (the image density detecting device). The color laser beam printer 101 can thus detect the luminance profiles in the first direction and the luminance profiles in the second direction of the positioning mark images 7 or the density detection patterns 9 at high speed by the extremely simple composition of disposing the plurality of photosensitive portions 12ₘₙ and 13ₘₙ in one pixel.

This invention is not limited to the above-described embodiment. For example, instead of using a shift register, it is possible to connect each of the photosensitive portions 12ₘₙ and 13ₘₙ (the second conductive type semiconductor regions 41 and 42) by uniform resistance wires. Thereafter, electric charges generated owing to incident light are obtained from an end of the resistance wire after resistive division of the electric charges is carried out so that the electric charges are inversely proportional to a distance between the end of each resistance wire and the position in the resistance wire into which the electric charges have been flown. Subsequently, a light incident position is obtained based on an electric current output from the end of each resistance wire.

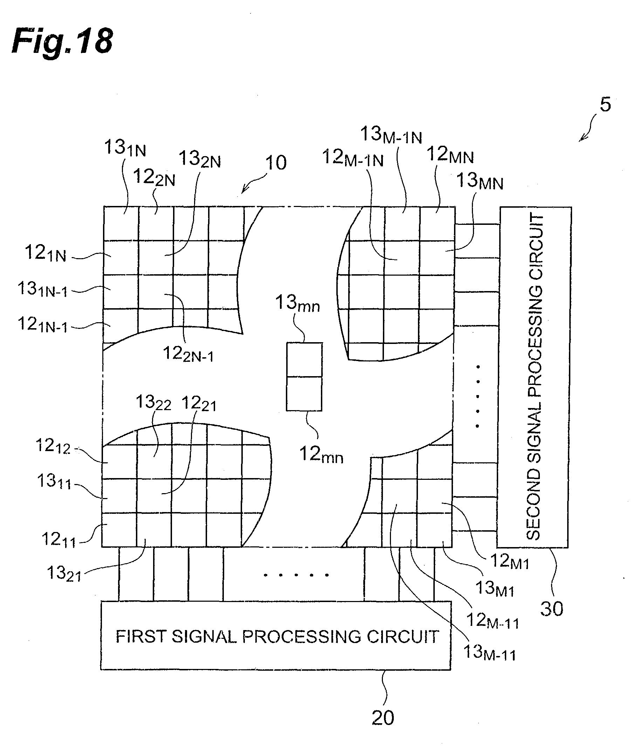

Furthermore, although one pixel is configured by the plurality of photosensitive portions in the aforementioned embodiment, one pixel may be configured by one photosensitive portion. As shown in Fig. 18, for example, a photosensitive region 10 includes a plurality of first photosensitive portions 12ₘₙ electrically connected to each other across the first direction, and a plurality of second photosensitive portions 13ₘₙ electrically connected to each other across the second direction. The plurality of first photosensitive portions 12ₘₙ and the plurality of second photosensitive portions 13ₘₙ may be arrayed to be two-dimensionally mixed within one plane. In this case, the first and second photosensitive portions 12ₘₙ and 13ₘₙ are arrayed in a checkered pattern, and alternately arrayed in the first and second directions. It is also possible to array the first and second photosensitive portions 12ₘₙ and 13ₘₙ in a honeycomb-like manner as shown in Fig. 12, in stead of the checkered pattern.

Moreover, though with the present embodiment, the same device is used in common as the multiple image position deviation detecting device and the image density detecting device, this invention is not limited thereto and the multiple image position deviation detecting device and the image density detecting device may be provided independently of each other. Also, besides the above-described color laser beam printer, this invention can be applied to a digital color copier or other multiple image forming device.

### Industrial Applicability

This invention's multiple image position deviation detecting device, image density detecting device, and multiple image forming device can be applied to a color laser beam printer, digital color copier, etc.

## Claims

1. A multiple image forming position deviation detecting device, wherein, in order to detect the deviations of transfer positions of images in forming a multiple image, multiple image forming position deviation detection patterns, formed on a surface of an object to be detected, are detected by a photodetecting means having a photosensitive region, in which pixels are arrayed two-dimensionally,
the multiple image position deviation detecting device wherein in the photodetecting means,
a single pixel is arranged by adjacently positioning within the same plane a plurality of photosensitive portions, each outputting a current in accordance with the intensity of light made incident thereon, and
in each plurality of pixels that are aligned in a first direction of the two-dimensional array, one photosensitive portion among the plurality of photosensitive portions making up each corresponding pixel is electrically connected to the same photosensitive portion of each of the other corresponding pixels, and
in each plurality of pixels that are aligned in a second direction of the two-dimensional array, another photosensitive portion among the plurality of photosensitive portions making up each corresponding pixel is electrically connected to the same photosensitive portion of each of the other corresponding pixels.

2. The multiple forming position deviation detecting device according to Claim 1, wherein the photodetecting means comprises:
a first signal processing circuit, reading the output from each the photosensitive portions that are electrically connected across each of the plurality of pixels aligned in the first direction to detect the luminance profile in the second direction of the two-dimensional array based on these outputs, and
a second signal processing circuit, reading the output from each of the photosensitive portions that are electrically connected across each the plurality of pixels aligned in the second direction to detect the luminance profile in the first direction of the two-dimensional array based on these outputs.

3. An image density detecting device, wherein, in order to detect the densities of an image, image density detection patterns, formed on a surface of an object to be detected, are detected by a photodetecting means having a photosensitive region, in which pixels are arrayed two-dimensionally,
the image density detecting device wherein in the photodetecting means,
a single pixel is arranged by adjacently positioning within the same plane a plurality of photosensitive portions, each outputting a current in accordance with the intensity of light made incident thereon, and
in each plurality of pixels that are aligned in a first direction of the two-dimensional array, one photosensitive portion among the plurality of photosensitive portions making up each corresponding pixel is electrically connected to the same photosensitive portion of each of the other corresponding pixels, and
in each plurality of pixels that are aligned in a second direction of the two-dimensional array, another photosensitive portion among the plurality of photosensitive portions making up each corresponding pixel is electrically connected to the same photosensitive portion of each of the other corresponding pixels.

4. The image density detecting device according to Claim 3, wherein the photodetecting means comprises:
a first signal processing circuit, reading the output from each of the photosensitive portions that are electrically connected across each the plurality of pixels aligned in the first direction to detect the luminance profile in the second direction of the two-dimensional array based on these outputs, and
a second signal processing circuit, reading the output from each the photosensitive portions that are electrically connected across each of the plurality of pixels aligned in the second direction to detect the luminance profile in the first direction of the two-dimensional array based on these outputs.

5. A multiple image forming device comprising:
a plurality of image forming units, respectively forming different images for forming a multiple image;
the multiple image forming position deviation detecting device according to Claim 1; and
wherein the deviations of the transfer positions of the images, respectively formed by the image forming units, are detected by means of the multiple image forming position deviation detecting device.

6. A multiple image forming device comprising:
a plurality of image forming units, respectively forming different images for forming a multiple image;
the image density detecting device according to Claim 3, and
wherein the densities of the images, respectively formed by the image forming units, are detected by means of the image density detecting device.
